(19) Europäisches Patentamt / European Patent Office / Office européen des brevets

(11) **EP 2 151 008 B1**

(12) **EUROPÄISCHE PATENTSCHRIFT**

(45) Veröffentlichungstag und Bekanntmachung des Hinweises auf die Patenterteilung:
**27.06.2012 Patentblatt 2012/26**

(21) Anmeldenummer: **08760013.6**

(22) Anmeldetag: **26.05.2008**

(51) Int Cl.:
*H01P 11/00* (2006.01)    *H03K 3/53* (2006.01)
*H05B 41/04* (2006.01)

(86) Internationale Anmeldenummer:
**PCT/EP2008/056414**

(87) Internationale Veröffentlichungsnummer:
**WO 2008/145631 (04.12.2008 Gazette 2008/49)**

(54) **HOCHSPANNUNGSIMPULSGENERATOR UND HOCHDRUCKENTLADUNGSLAMPE MIT DERARTIGEM GENERATOR**

HIGH-VOLTAGE PULSE GENERATOR AND HIGH-PRESSURE DISCHARGE LAMP HAVING SUCH A GENERATOR

GÉNÉRATEUR D'IMPULSIONS À HAUTE TENSION ET LAMPE A DÉCHARGE À HAUTE PRESSION COMPRENANT UN TEL GÉNÉRATEUR

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **29.05.2007 DE 102007024890**

(43) Veröffentlichungstag der Anmeldung:
**10.02.2010 Patentblatt 2010/06**

(73) Patentinhaber: **OSRAM AG**
**81536 München (DE)**

(72) Erfinder:
• **KLOSS, Andreas**
**85579 Neubiberg (DE)**
• **SCHALK, Bernhard**
**82008 Unterhaching (DE)**
• **WALTER, Steffen**
**85667 Oberpframmern (DE)**

(56) Entgegenhaltungen:
| | |
|---|---|
| **EP-A- 0 436 200** | **JP-A- 1 096 911** |
| **JP-A- 2005 033 579** | **US-A- 4 353 012** |
| **US-A1- 2003 128 082** | |

EP 2 151 008 B1

**Beschreibung**

Technisches Gebiet

Die Erfindung geht aus von einem Hochspannungsimpulsgenerator gemäß dem Oberbegriff des Anspruchs 1. Derartige Generatoren lassen sich insbesondere für Hochdruckentladungslampen für Allgemeinbeleuchtung oder für fotooptische Zwecke oder für Kfz einsetzen. Die Erfindung betrifft weiterhin eine Hochdruckentladungslampe, die mit einem derartigen Generator ausgestattet ist.

Stand der Technik

Das Problem der Zündung von Hochdruckentladungslampen wird derzeit dadurch gelöst, dass das Zündgerät in das Vorschaltgerät integriert ist. Nachteilig daran ist, dass die Zuleitungen hochspannungsfest ausgelegt sein müssen.

In der Vergangenheit hat es immer wieder Versuche gegeben, die Zündeinheit in die Lampe zu integrieren. Dabei wurde versucht, sie in den Sockel zu integrieren. Eine besonders effektive und hohe Pulse versprechende Zündung gelingt mittels Hochspannungspulsgeneratoren des Typs Spiral-Puls-Generator. Vor längerer Zeit wurden derartige Geräte bei verschiedenen Hochdruckentladungslampen wie Metallhalogenidlampen oder Natriumhochdrucklampen vorgeschlagen, siehe beispielsweise US-A 4 325 004 und US-A 4 353 012. Sie konnten sich jedoch nicht durchsetzen, weil sie zum einen zu teuer sind. Zum andern ist der Vorteil, sie in den Sockel einzubauen, nicht ausreichend, da das Problem des Zuführens der Hochspannung in den Kolben bleibt. Die Wahrscheinlichkeit für Schädigungen der Lampe, seien es Isolationsprobleme oder ein Durchbruch im Sokkel, steigt daher stark an. Bisher übliche Zündgeräte konnten im allgemeinen nicht über 100 °C erwärmt werden. Die erzeugte Spannung musste dann der Lampe zugeführt werden, was Leitungen und Lampenfassungen mit entsprechender Hochspannungsfestigkeit erfordert, typisch etwa 5 kV.

In üblichen Zündschaltungen wird normalerweise ein Kondensator über einen Schalter, z.B. eine Funkenstrecke, in die Primärwicklung eines Zündtrafos entladen. In der Sekundärwicklung wird dann der gewünschte Hochspannungspuls induziert. Siehe dazu Sturm/Klein, Betriebsgeräte und Schaltungen für elektrische Lampen, S. 193 bis 195 (6. Auflage 1992).

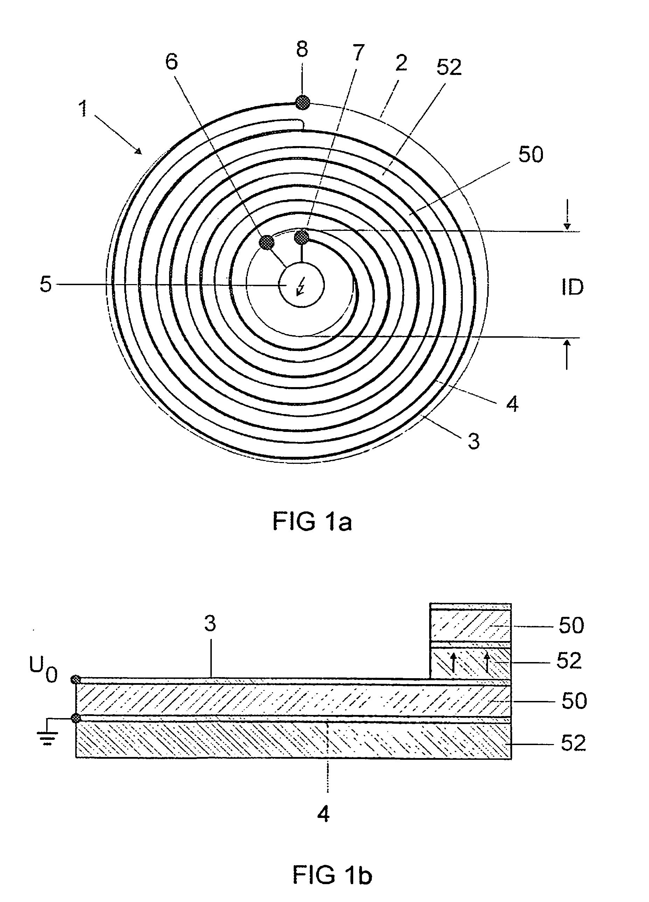

Fig. 1b zeigt den Schichtaufbau eines herkömmlichen Spiral-Puls-Generators, wie er bisher verwendet wurde. Zwischen zwei Metallschichten 3 und 4 ist eine aktive dielektrische Schicht 50 angeordnet. Die Schicht besteht aus einem kapazitiv wirkenden Material mit hohem $\varepsilon_r$. Zwischen den beiden Metallschichten liegt die Spannung U0 an. Da dieser Lagenaufbau aufgewickelt wird, ist eine weitere Isolationsschicht notwendig. Diese besteht aus einem induktivem Material 52 mit einer

hohen Permeabilität μr. Da die meisten induktiven Materialien aber keine guten Isolatoren sind, und an der induktiven Schicht ebenfalls die Spannung U0 anliegt, bildet sich durch die induktive Schicht ein Leckstrom aus, wie in Fig. 1b durch die Pfeile angedeutet ist. Dies stellt eine erhebliche Performanceeinbuße des Spiral-Puls-Generators dar. Auch die mögliche Ladespannung des Spiral-Puls-Generators wird dadurch stark beeinträchtigt.

Darstellung der Erfindung

Die Aufgabe der vorliegenden Erfindung ist es, einen Hochspannungspulsgenerator bereitzustellen, dessen Impedanz und Pulsbreite in einem großen Rahmen möglichst frei wählbar ist.

Diese Aufgabe wird gelöst durch die kennzeichnenden Merkmale des Anspruchs 1.

Besonders vorteilhafte Ausgestaltungen finden sich in den abhängigen Ansprüchen.

Weiterhin ist eine Aufgabe der vorliegenden Erfindung, eine kompakte Hochdruckentladungslampe anzugeben. Diese Aufgabe wird durch die kennzeichnenden Merkmale des Anspruchs 14 gelöst.

Eine weitere Aufgabe ist es, ein Verfahren zur Herstellung solch eines kompakten Spiralpulsgenerators anzugeben.

Diese Aufgabe wird gelöst durch die kennzeichnenden Merkmale des Anspruchs 11.

Erfindungsgemäß wird jetzt ein Hochspannungspuls mit mindestens 1,5 kV, der beispielsweise zur Zündung einer Lampe notwendig ist, mittels eines speziellen temperaturresistenten Spiral-Puls-Generators erzeugt.

Insbesondere kann dieser bei Anwendung in einer Hochdruckentladungslampe in unmittelbarer Nähe des Entladungsgefäßes im Außenkolben integriert werden. Nicht nur eine Kaltzündung sondern auch ein Heißwiederzündung ist damit möglich.

Der jetzt verwendete Spiral-Puls-Generator ist insbesondere ein sog. LTCC-Bauteil. Dieses Material ist eine spezielle Keramik, die bis 600 °C Temperaturfest gemacht werden kann. Zwar wurde LTCC schon in Zusammenhang mit Lampen verwendet, siehe US 2003/0001519 und US-B 6 853 151. Jedoch wurde es für ganz andere Zwecke bei praktisch kaum temperaturbelasteten Lampen, mit typischen Temperaturen unter 100 °C, eingesetzt. Der besondere Wert der hohen Temperaturstabilität von LTCC ist in Zusammenhang mit der Zündung von Hochdruckentladungslampen, wie vor allem Metallhalogenidlampen mit Zündproblemen, zu erkennen.

Der Spiral-Puls-Generator ist ein Bauteil, das Eigenschaften eines Kondensators mit denen eines Wellenleiters zur Erzeugung von Zündpulsen mit einer Spannung von mindestens 1,5 kV vereint, Für die Herstellung werden zwei keramische "Grün-Folien" mit metallischer Leitpaste bedruckt oder auf eine Metallfolie auflaminiert und anschließend versetzt zu einer Spirale aufgewickelt und schließlich isostatisch zu einem Formkörper gepresst. Die folgende Co-Sinterung von Metallpaste/folie und keramischer Folie erfolgt an Luft im Temperaturbereich zwischen 800 und 900 °C. Diese Verarbeitung erlaubt einen Einsatzbereich des Spiral-Puls-Generators bis 700 °C Temperaturbelastung. Dadurch kann der Spiral-Puls-Generator in direkter Nähe des Entladungsgefäßes im Außenkolben, aber auch im Sockel oder in unmittelbarer Nähe der Lampe untergebracht werden.

Unabhängig davon kann ein derartiger Spiral-Puls-Generator auch für andere Anwendungen eingesetzt werden, weil er nicht nur hochtemperaturstabil ist, sondern auch äußerst kompakt. Dafür ist wesentlich, dass der Spiral-Puls-Generator als LTCC-Bauteil ausgeführt ist, bestehend aus Keramikfolien und metallischer Leitpaste beziehungsweise einer Folie. Um ausreichend Ausgangspannung zu liefern, sollte die Spirale mindestens 5 Windungen umfassen.

Zudem lässt sich auf Basis dieses Hochspannungspulsgenerators eine Zündeinheit angeben, die weiterhin zumindest einen Ladewiderstand und einen Schalter umfasst. Der Schalter kann eine Funkenstrecke oder auch ein Diac in SiC-Technologie sein.

Bevorzugt ist im Falle einer Anwendung für Lampen die Unterbringung im Außenkolben. Denn dadurch entfällt die Notwendigkeit einer hochspannungsfesten Spannungszuleitung.

Zudem lässt sich ein Spiral-Puls-Generator so dimensionieren, dass der Hochspannungspuls sogar eine Heißwiederzündung der Lampe ermöglicht. Das Dielektrikum aus Keramik zeichnet sich durch eine außergewöhnlich hohe Dielektrizitätskonstante $\varepsilon$ von $\varepsilon > 10$ aus, wobei je nach Material und Bauweise ein $\varepsilon$ von typisch 70, bis zu $\varepsilon = 10000$ erreicht werden kann. Das schafft eine sehr hohe Kapazität des Spiral-Puls-Generators und ermöglicht eine vergleichsweise große zeitliche Breite der erzeugten Impulse. Dadurch wird eine sehr kompakte Bauweise des Spiral-Puls-Generators möglich, so dass ein Einbau in handelsübliche Außenkolben von Hochdruckentladungslampen gelingt. Die große Pulsbreite erleichtert zudem den Durchschlag im Entladungsvolumen.

Als Material des Außenkolbens kann jedes übliche Glas verwendet werden, also insbesondere Hartglas, Vycor oder Quarzglas. Auch die Wahl der Füllung unterliegt keiner besonderen Einschränkung.

Aus der DE 10 2006 026 751 A1 ist bereits bekannt, dass eine besonders einfache Anpassung der gewünschten Eigenschaften eines LTCC-Spiral-Puls-Generators erreicht wird, indem als Dielektrikum nicht einfach ein Material mit gewünschter Dielektrizitätskonstante verwendet wird, sondern eine Mischung aus zwei Materialien, von denen ein erstes Material ein Dielektrikum mit einem gegebenen $\varepsilon_r$ ist und das zweite Material ein gegebenes $\mu_r$, also eine relative Permeabilität, besitzt. Während bisher ein einfaches Material mit einem $\varepsilon_r$ von 4 bis 10000 verwendet wurde, kann nach der Lehre von DE 10 2006 026 751 A1 eine Mischung verwendet werden, bei der das erste Material ein $\varepsilon$: von 2 bis 10000 haben kann, während das zweite Material induktiv ist und ein $\mu_r$ von 1 bis 5000 haben kann. Bevorzugt ist $\mu_r$ möglichst hoch, und beträgt mindestens 10, besonders bevorzugt mindestens 100. Bisher lag der Wert von $\mu_1$ bei den bekannten Materialien nahe bei 1; eine Anpassung war nicht möglich. Als typische Mischung wird dort ein Anteil von 5 bis 35 Gew.-% des induktiven Materials vorgeschlagen.

Es ist jedoch möglich und demgegenüber sogar vorteilhaft, einen anderen Weg einzuschlagen: Dadurch, dass das schlecht isolierende induktive Material jetzt in einem dreilagigen Aufbau von je einer Lage des gut isolierenden kapazitiven Materials umschlossen ist, ist insgesamt eine gute Isolationsfestigkeit gewährleistet, da das gut isolierende kapazitive Material das induktive isoliert.

Der besondere Wert des neuartigen Freiheitsgrades ist die separate Anpassung und Einstellung der dielektrischen und induktiven Eigenschaften eines Spiralpulsgenerators, so dass eine maßgeschneiderte Einstellung der Impedanz des Spiralpulsgenerators und der Pulsbreite des erzeugten Hochspannungspulses möglich wird. Grundsätzlich erschließt sich die Bedeutung der separaten Einstellbarkeit aus folgender Überlegung:

Für die Anpassung von Pulsbreite, Wellenwiderstand und Pulsenergie eines Spiralpulsgenerators sollte $\mu$ und $\varepsilon$ gemäß folgender Richtschnur gewählt werden : Der Wellenwiderstand (Impedanz) $Z_0$ eines Spiralgenerators ist gegeben durch $Z_0 \sim \sqrt{\dfrac{\mu_0 \cdot \mu_r}{\varepsilon_0 \cdot \varepsilon_r}}$ mit $\mu_0$ - Induktionskonstante, $\varepsilon_0$ - Influenzkonstante, $\mu_r$ - relative Permeabilität und $\varepsilon_r$ - relative Dielektrizitätskonstante. Die Energie des erzeugten Pulses ist proportional zu $\varepsilon_r$. Die Pulsbreite des Spiral-Puls-Generators ist durch $\tau \sim \sqrt{\mu_0 \cdot \mu_r \cdot \varepsilon_0 \cdot \varepsilon_r}$ gegeben. Für eine effiziente Funktionsweise des Generators muss gelten $L_s << (Z_0 \cdot \tau)$ mit $L_s$ - Induktivität des Kurzschlussschalters. Wegen $Z_0 \cdot \tau \sim \mu_r$ lässt sich diese Anpassung an die Induktivität des Kurzschlussschalters über die Wahl der relativen Permeabilität erreichen.

Spiralpulsgeneratoren sind im Allgemeinen aus jeweils zwei als Spirale gestalteten Schichten eines Leiters und eines Isolators aufgebaut. Details dazu finden sich insbesondere in DE 10 2005 061 832 A1. Die beiden nichtleitenden Schichten bestehen dabei aus demselben Material. Durch Wahl dieses Materials sind die Permeabilität p und die Permittivität $\varepsilon$ fest eingestellt, die letztlich die Eigenschaften des Spiralpulsgenerators bestimmen. Wesentliche Eigenschaften sind die Impedanz L des Wellenleiters, wobei $Z \sim \sqrt{(\mu/\varepsilon)}$, oder Anstiegszeit $\tau$ des generierten Pulses, wobei $\tau \sim 1/(\varepsilon^* \mu)$.

Aufgrund vorgegebener Materialeigenschaften

sind isolierende Schichten mit gewünscht gleichzeitig hohen Werten von μ und ε wie im zitierten Stand der Technik vorgeschlagen nur begrenzt und nicht frei wählbar verfügbar. Die Verwendung eines Mischferrits ist aufwendig herzustellen. Eine andere Möglichkeit, die in DE 10 2006 026 750 A1 erläutert ist, ist die Verwendung eines einheitlichen homogenen Materials als guter Isolator mit gegebenem hohem ε, und nachfolgender Umhüllung des Spiral-Puls-Generators mit induktivem Material mit hoher Permeabilität μ. Diese Technik der Umhüllung erfordert jedoch ein Material mit außerordentlich hohem μ, was umgekehrt aber aufgrund der niedrigen Curietemperatur eines solchen Materials eine Hochtemperaturanwendung nur sehr begrenzt zulässt. Außerdem ist eine nachträgliche Umhüllung des gesamten Spiral-Puls-Generators sehr volumenintensiv und damit ungünstig.

Um eine frei wählbare Parametrisierung der Eigenschaften zu verschaffen wird ein Spiralpulsgenerator so aufgebaut, dass für die aktive Schicht und für die passive Schicht verschiedene Materialien oder ein mehrlagiger Aufbau verwendet wird.

In einer ersten Ausführungsform besitzen die aktive und die passive Schicht verschiedene Eigenschaften. Für die Eigenschaften der aktiven Schicht eines Spiralpulsgenerators, der aus keramischen Folien aufgebaut ist, ist hauptsächlich die Permittivität ε veranwortlich, während die Permeabilität μ durch die passive Schicht bestimmt wird.

In einer zweiten Ausführungsform bestehen die aktiven und passiven Schichten aus einem mehrlagigem Aufbau. Dabei wird die aktive Schicht des Spiral-Puls-Generators aus 3 keramischen Schichten aufgebaut: Es wird eine Lage induktiven Materials von zwei Lagen kapazitiven Materials eingeschlossen. Baut man den Spiralpulsgenerator so auf, dass die kapazitive Schicht ein hohes $\varepsilon_r$ von mindestens 10, bevorzugt im Bereich $\varepsilon_r$ = 10 bis 10000, besitzt, während die induktive Schicht ein anderes Material verwendet, das sich durch eine hohe Permeabilität auszeichnet, mit $\mu_r$ = 1 bis 5000, bevorzugt μ > 2, so können die jeweils einzeln verfügbaren Materialeigenschaften in Kombination verwendet werden, um eine möglichst freie Parametrisierung der Eigenschaften zu gewährleisten. Ein solcher Aufbau ist sehr verlustarm, da das kapazitive Material hochisolierend ist. Damit wird auch die Verwendung von induktiven Material mit mittlerer Permeabilität $\mu_r$ und gleichzeitig hoher Curietemperatur möglich.

Als Material für die kapazitive Schicht eignet sich bevorzugt ein Titanat wie $BaTiO_3$ oder $(Ba, Sr) TiO_3$. Als Material für die induktive Schicht eignet sich insbesondere ein Ferrit wie ein Mn/Zn-Ferrit.

Kurze Beschreibung der Zeichnungen

Im Folgenden soll die Erfindung anhand mehrerer Ausführungsbeispiele näher erläutert werden. Die Figuren zeigen:

Fig. 1a einen herkömmlichen Spiralpulsgenerator nach dem Aktiv-Passiv-Konzept;

Fig. 1b den schematischen Aufbau der Schichtfolge eines herkömmlichen Spiral-Puls-Generators nach dem Aktiv-Passiv-Konzept;

Fig. 2 die Kenngrößen eines LTCC- Spiral-Puls-Generators;

Fig. 3a den schematischen Aufbau der Schichtfolge eines erfindungsgemäßen Spiral-Puls-Generators mit einem dreilagigen Aufbau zwischen den Metallschichten;

Fig. 3b den schematischen Aufbau der Lagen nach dem erfindungsgemäßen Herstellverfahren;

Fig. 4 den Prinzipaufbau einer Natriumhochdrucklampe mit Spiral-Puls-Generator im Außenkolben.

Fig. 5 den Prinzipaufbau einer Metallhalogenidlampe mit Spiral-Puls-Generator im Außenkolben.

Fig. 6 eine Metallhalogenidlampe mit Spiral-Puls-Generator im Außenkolben;

Fig. 7 eine Metallhalogenidlampe mit Spiral-Puls-Generator im Sockel.

Bevorzugte Ausführungsform der Erfindung

Ein klassischer Spiral-Puls-Generator wird entweder aus zwei mit Metallpaste beschichteten keramischen Folien gewickelt oder aus zwei Metallfolien und zwei keramischen Folien aufgebaut. Eine wichtige Kenngröße ist dabei die Zahl n der Windungen, die bevorzugt in der Größenordnung 5 bis 100 liegen soll. Diese Wikkelanordnung wird dann laminiert und anschließend gesintert, wodurch ein LTCC-Bauteil entsteht. Die so geschaffenen Spiral-Puls-Generatoren mit Kondensatoreigenschaft werden dann mit einer Funkenstrecke sowie einem Ladewiderstand beschaltet. Die Funkenstrecke fungiert als Hochspannungsschalter, der den Puls initiiert. Die keramische Folie ist hier eine Mischung aus dielektrischem Material mit $\varepsilon_r$ zwischen 2 und 10000 und induktivem Material mit $\mu_r$ zwischen 1,5 und 5000.

Die Funkenstrecke kann sich an den inneren oder den äußeren Anschlüssen oder auch innerhalb der Wicklung des Generators befinden. Ebenfalls kann ein auf SiC basierender Halbleiterschalter z.B. ein MESFET der Fa. Cree verwendet werden. Dieser ist sehr temperaturstabil und für Temperaturen oberhalb 350 °C geeignet.

In einem konkreten Ausführungsbeispiel wird ein Keramikmaterial mit ε = 60 bis 70 verwendet. Dabei wird bevorzugt als Dielektrikum eine Keramikfolie, insbesondere ein Keramikband wie Heratape CT 707 oder bevorzugt CT 765 oder auch eine Mischung beider, jeweils von Heraeus verwendet. Es hat eine Dicke der grünen Folie von typisch 50 bis 150 $\mu$m. Als Leiter wird insbesondere Ag-Leitpaste wie "Cofirable Silver," ebenfalls von Heraeus, verwendet. Ein konkretes Beispiel ist CT 700 von Heraeus. Gute Ergebnisse liefert auch die Metallpaste 6142 von DuPont. Diese Teile lassen sich gut laminieren und danach ausheizen ("burnout") und zusammen sintern ("co-firing").

Der Innendurchmesser ID des Spiral-Puls-Generators ist 10 mm. Die Breite der einzelnen Streifen ist ebenfalls 10 mm. Die Foliendicke beträgt 50 $\mu$m und auch die Dicke der beiden Leiter ist jeweils 50 $\mu$m. Die Ladespannung beträgt 300 V. Unter diesen Voraussetzungen erreicht der Spiral-Puls-Generator ein Optimum seiner Eigenschaften bei einer Windungszahl von n = 20 bis 70.

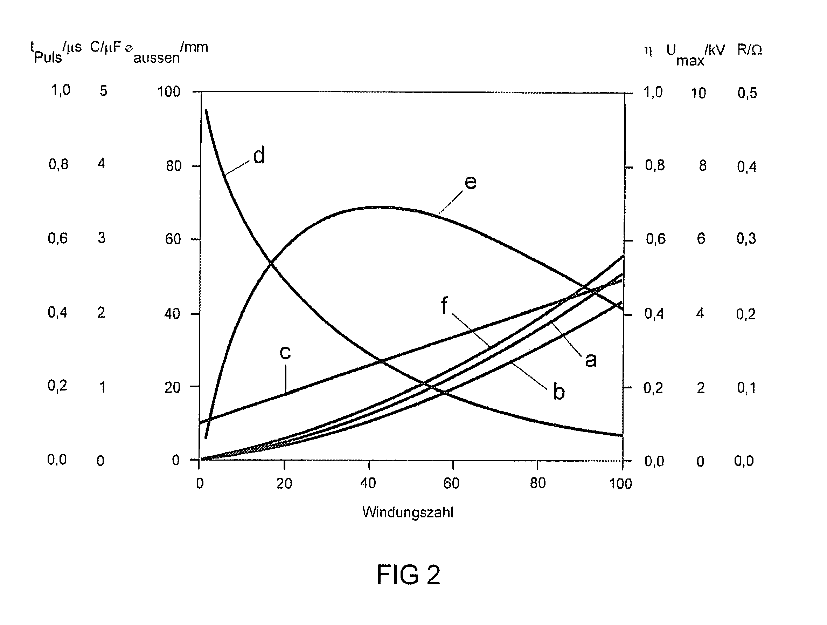

In Figur 2 sind die zugehörige Halbwertsbreite des Hochspannungspulses in $\mu$s (Kurve a), die Gesamtkapazität des Bauteils in $\mu$F (Kurve b), der resultierende Außendurchmesser in mm (Kurve c), sowie die Effizienz (Kurve d), die maximale Pulsspannung (Kurve e) in kV und der Leiterwiderstand in Q (Kurve f) dargestellt.

Erste Ausführungsform

Figur 1a zeigt den Aufbau der ersten Ausführungsform eines Spiral-Puls-Generators 1 in Draufsicht. Er besteht aus einem keramischen Zylinder 2, in den zwei verschiedene metallische Leiter 3 und 4 als Folienband spiralförmig eingewickelt sind. Der Zylinder 2 ist innen hohl und besitzt einen gegebenen Innendurchmesser ID. Die beiden inneren Kontakte 6 und 7 der beiden Leiter 3 und 4 liegen bevorzugt nebeneinander und sind über eine Funkenstrecke 5 miteinander verbunden. Zwischen den beiden metallischen Leitern liegen die beiden keramischen Folien, die jeweils als Isolatoren dienen, und aus unterschiedlichen Materialien hergestellt sind. Dabei wird eine Folie 50 aus Material mit hohem $\epsilon$ hergestellt, insbesondere BaTiO$_3$. Diese Folie wirkt im Spiralpulsgenerator als aktive Schicht. Die zweite Folie 52 wird aus einem Material mit hohem $\mu$ hergestellt, insbesondere Mn/Zn-Ferrit. Diese Folie wirkt im Spiralpulsgenerator als passive Schicht. Vorzugsweise ist die aktive Schicht in der Wicklung des Spiralpulsgenerators diejenige, die über die nebeneinander liegenden Kontakte 6 und 7 kurzgeschlossen wird.

Nur der äußere der beiden Leiter besitzt am äußeren Rand des Zylinders einen weiteren Kontakt 8. Der andere Leiter endet offen. Die beiden Leiter bilden dadurch zusammen einen Wellenleiter in einem dielektrischen Medium, der Keramik.

Bei einem alternativen Aufbau sind beide Kontakte für den Kurzschlußschalter außen am Ring und der einzelne Kontakt innen.

Fig. 1b zeigt den Schichtaufbau dieses Spiral-Puls-Generators, wie er bisher verwendet wurde. Zwischen zwei Metallschichten 3 und 4 ist eine aktive dielektrische Schicht 50 angeordnet. Die Schicht besteht aus einem kapazitiv wirkenden Material mit hohem $\epsilon_r$. Zwischen den beiden Metallschichten liegt die Spannung $U_0$ an. Da dieser Lagenaufbau aufgewickelt wird, ist eine weitere Isolationsschicht notwendig. Diese besteht aus einem induktiven Material 52 mit einer hohen Permeabilität $\mu_r$. Da die meisten induktiven Materialien aber keine guten Isolatoren sind, und an der induktiven Schicht ebenfalls die Spannung $U_0$ anliegt, bildet sich durch die induktive Schicht ein Leckstrom aus, wie in Fig. 1b durch die Pfeile angedeutet ist. Dies stellt eine gewisse Performanceeinbuße des Spiral-Puls-Generators dar. Auch die mögliche Ladespannung des Spiral-Puls-Generators wird dadurch beeinträchtigt.

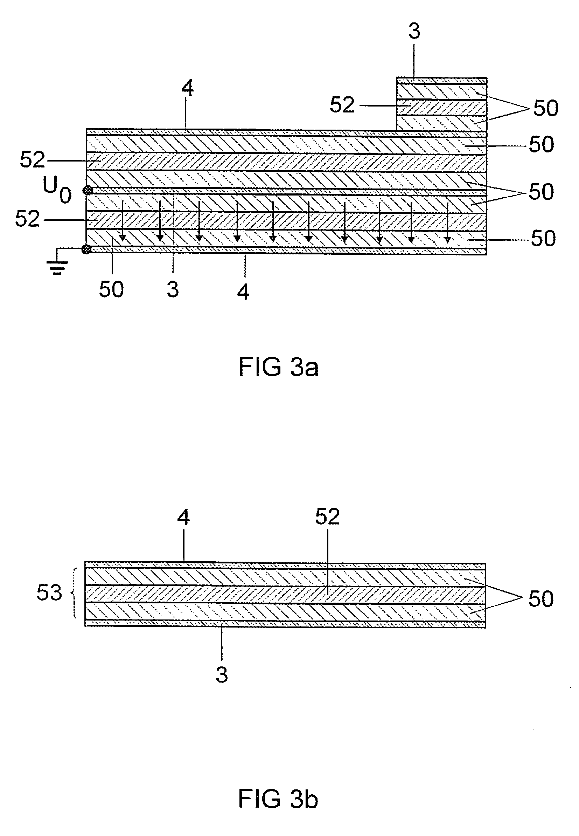

Fig. 3a zeigt den schematischen Aufbau eines erfindungsgemäßen Spiral-Puls-Generators in der Abwicklung. Zwischen den beiden metallischen Schichten 3 und 4, zwischen denen die Spannung $U_0$ anliegt, ist eine Schicht aus drei Lagen angeordnet. Dabei wird eine Lage induktiven Materials 52 von zwei Lagen kapazitiven Materials 50 eingeschlossen. Dies hat eine gute elektrische Isolation des Materials 52 gegenüber den leitenden Metallschichten 3 und 4 zur Folge, woraufhin ein störender Kriechstrom sicher unterbunden werden kann. Die Schichten 50a und 52a zeigen die eigentlich nächsten Schichten, wie sie in einem Wickel aufeinander folgen würden.

Die drei keramischen Schichten 53, die in Fig. 3b gezeigt sind werden in einem Foliengießverfahren (Tapecastingverfahren) aufgebaut. Als erstes wird die kapazitiv wirkende Keramikschicht 50 hoher Permittivität auf eine Trägerfolie gegossen. Die in diesem Schlicker enthaltene Keramik kann z.B. BaTiO$_3$ oder BaSrTiO$_3$ oder eine andere geeignete kapazitiv wirkende Keramik sein. Nach dem Trocknen dieser Schicht wird in einem zweiten Schritt eine induktiv wirkende Keramikschicht 52 gegossen. Im Schlicker kann ein Vertreter der Stoffsysteme aus Ba-Hexaferrit, NiZnCu-Ferrit oder ein MnZn-Ferrit hoher Permeabilität enthalten sein. Daraufhin wird auch diese Schicht getrocknet. In einem dritten Schritt wird schließlich noch einmal das Schlickersystem der ersten Schicht 50 über das Foliengießverfahren auf die induktiv wirkende zweite Schicht 52 gegossen. Somit ist ein Dreischichtsystem entstanden, in dem die Ferritschicht hoher Permeabilität zwischen zwei Schichten hoher Permittivität eingebettet ist. Der elektrische Stromfluss beim Anlegen einer Spannung durch die Ferritschicht wird nun durch die permittiven Schichten unterbunden, da sie als Isolationsschichten mit hoher Kapazität wirken.

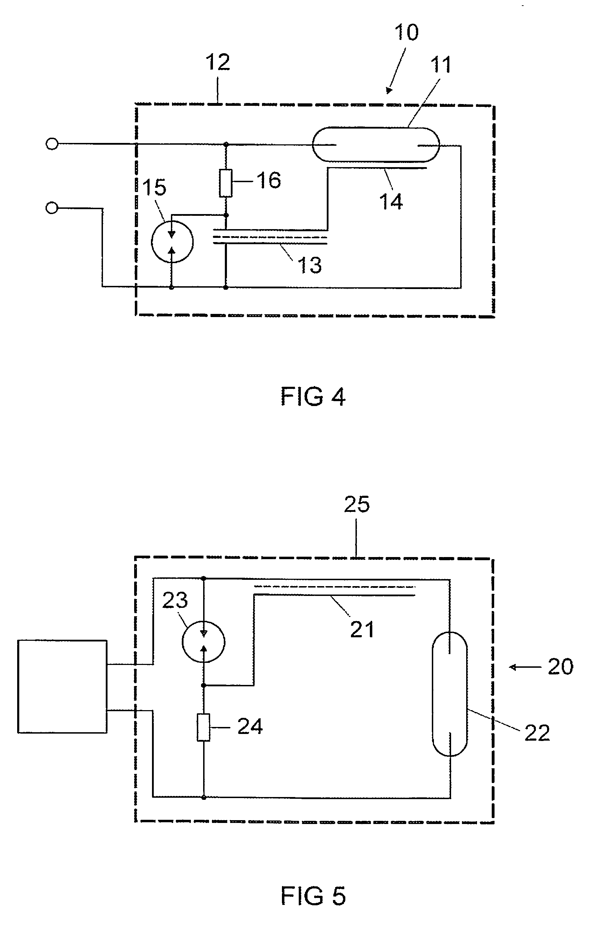

Figur 4 zeigt den prinzipiellen Aufbau einer Natriumhochdrucklampe 10 mit keramischem Entladungsgefäß 11 und Außenkolben 12 mit darin integriertem Spiral-Puls-Generator 13, wobei eine Zünd-Elektrode 14 außen am keramischen Entladungsgefäß 11 angebracht ist. Der Spiral-Puls-Generator 13 ist mit der Funkenstrecke 15 und dem Ladewiderstand 16 im Außenkolben untergebracht.

Figur 5 zeigt den prinzipiellen Aufbau einer Metallhalogenidlampe 20 mit integriertem Spiral-Puls-Generator 21, wobei keine Zünd-Elektrode außen am Entladungsgefäß 22, das aus Quarzglas oder Keramik gefertigt sein kann, angebracht ist. Der Spiral-Puls-Generator 21 ist mit der Funkenstrecke 23 und dem Ladewiderstand 24 im Außenkolben 25 untergebracht.

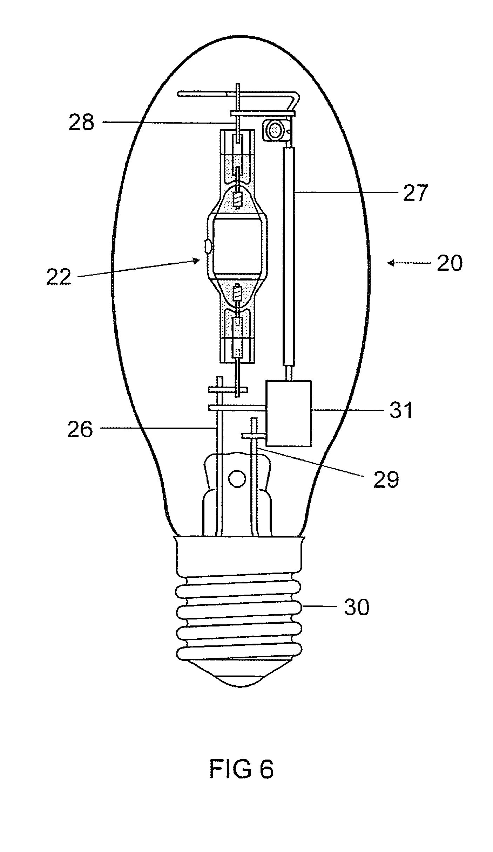

Figur 6 zeigt eine Metallhalogenidlampe 20 mit einem Entladungsgefäß 22, welches von zwei Zuleitungen 26, 27 in einem Außenkolben gehalten wird. Die erste Zuleitung 26 ist ein kurz abgewinkelter Draht. Die zweite 27 ist im wesentlichen ein Stab, der zur sockelfernen Durchführung 28 führt. Zwischen der Zuleitung 29 aus dem Sockel 30 und dem Stab 27 ist eine Zündeinheit 31 angeordnet, die den Spiral-Puls-Generator, die Funkenstrecke und den Ladewiderstand enthält, wie in Figur 4 angedeutet.

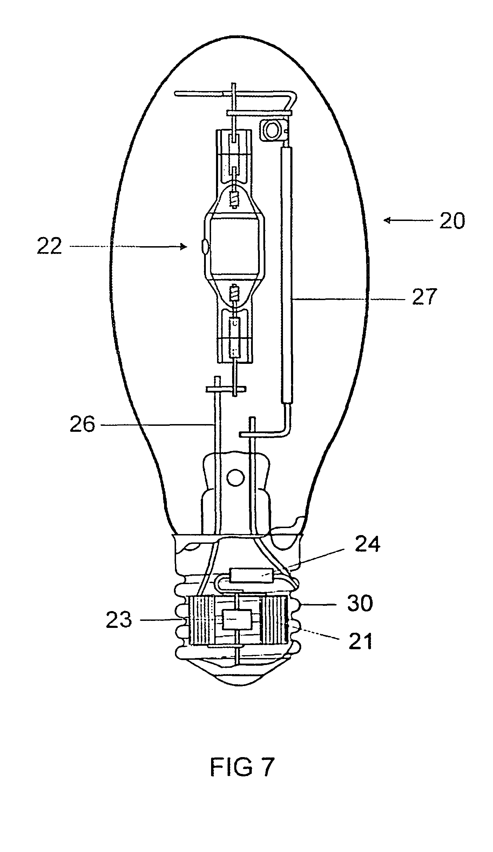

Figur 7 zeigt eine Metallhalogenidlampe 20 ähnlich wie Figur 5 mit einem Entladungsgefäß 22, welches von zwei Zuleitungen 26, 27 in einem Außenkolben 25 gehaltert wird. Die erste Zuleitung 26 ist ein kurz abgewinkelter Draht. Die zweite 27 ist im wesentlichen ein Stab, der zur sockelfernen Durchführung 28 führt. Hier ist die Zündeinheit im Sockel 30 angeordnet, und zwar sowohl der Spiral-Puls-Generator 21, als auch die Funkenstrecke 23 und der Ladewiderstand 24.

Diese Technik kann auch für elektrodenlose Lampen angewendet werden, wobei der Spiral-Puls-Generator als Zündhilfe dienen kann.

Weitere Anwendungen dieses kompakten Hochspannungspulsgenerators liegen in der Zündung anderer Geräte. Die Anwendung ist vor allem bei sog. magischen Kugeln, bei der Erzeugung von Röntgenpulsen und der Erzeugung von Elektronenstrahl-Pulsen vorteilhaft. Auch ein Einsatz in Kraftfahrzeugen als Ersatz für die üblichen Zündspulen ist möglich.

Dabei werden Windungszahlen von n bis 500 verwendet, so dass die Ausgangsspannung bis in die Größenordnung von 100 kV erreicht. Denn die Ausgangsspannung $U_A$ ist als Funktion der Ladespannung U gegeben durch $U_A = 2 \times n \times U_L \times n$, wobei die Effizienz $\eta$ durch $\eta = (AD-ID)/AD$ gegeben ist.

Die Erfindung entfaltet besondere Vorteile im Zusammenwirken mit Hochdruckentladungslampen für Autoscheinwerfer, die mit Xenon unter hohem Druck von bevorzugt mindestens 3 bar und Metallhalogeniden gefüllt sind. Diese sind besonders schwer zu zünden, da wegen des hohen Xenondrucks die Zündspannung mehr als 10 kV beträgt. Derzeit werden die Komponenten der Zündeinheit im Sockel untergebracht. Ein Spiral-Puls-Generator mit integriertem Ladewiderstand kann entweder in den Sockel der Kfz-Lampe oder in einem Außenkolben der Lampe untergebracht sein.

Die Erfindung entfaltet ganz besondere Vorteile im Zusammenwirken mit Hochdruckentladungslampen, die kein Quecksilber enthalten. Derartige Lampen sind aus Umweltschutzgründen besonders erstrebenswert.

Sei enthalten eine geeignete Metallhalogenidfüllung und insbesondere ein Edelgas wie Xenon unter hohem Druck. Wegen des fehlenden Quecksilbers ist die Zündspannung besonders hoch. Sie beträgt mehr als 20 kV. Derzeit werden die Komponenten der Zündeinheit im Sockel untergebracht. Ein Spiral-Puls-Generator mit integriertem Ladewiderstand kann entweder in den Sockel der Quecksilberfreien Lampe oder in einen Außenkolben der Lampe untergebracht sein.

Als Material für die passive Schicht eignen sich neben Mn-Zn-Ferrit grundsätzlich auch andere bekannte Ferrite, beispielsweise Eisenoxide. Die relative Permeabilität sollte mindestens 1,5 betragen. In aller Regel wird $\mu_r$ bei 4 bis 15000 gewählt. Geeignet ist insbesondere Eisenoxid mit Dotierung. Als Dotierstoff kommt ggf. beispielsweise Mg oder Al in Frage. Andere geeignete Metalloxide sind die des Nickels, Mangans, Magnesiums, Zinks und Cobalts, einzeln oder in Mischung, insbesondere Ni-Zn. Dabei ist die Permeabilität häufig mindestens zu $\mu_r = 10$ gewählt.

**Patentansprüche**

1.  Hochspannungsimpulsgenerator auf der Basis eines Spiral-Puls-Generators, wobei der Spiral-Puls-Generator als LTCC-Bauteil ausgeführt ist und aus mindestens zwei Keramikfolien (50, 52) und mindestens zwei metallischen Schichten (3, 4) gewickelt ist, **dadurch gekennzeichnet, dass** die zwei Keramikfolien (50, 52) zu einem mehrlagigem Aufbau aus mindestens einer ersten Lage einer kapazitiv wirkenden Keramikfolie (50) mit einer hohen Permittivität von mindestens $\varepsilon_r = 10$ und mindestens einer zweiten Lage einer induktiv wirkenden Keramikfolie (52) mit einer hohen Permeabilität von mindestens $\mu_r = 1,5$ verbunden sind, die zusammen mit den metallischen Schichten zu einer Spirale aufgewickelt sind.

2.  Hochspannungsimpulsgenerator nach Anspruch 1, **dadurch gekennzeichnet, dass** sich der mehrlagige Aufbau der Keramikfolien (50, 52) zwischen den metallischen Schichten (3, 4) des Spiral-Puls-Generators befindet.

3.  Hochspannungsimpulsgenerator nach Anspruch 1, **dadurch gekennzeichnet, dass** die mindestens eine induktiv wirkende Keramikfolie (52) durch die mindestens eine kapazitiv wirkende Keramikfolie (50) gegenüber mindestens einer metallischen Schicht isoliert ist.

4.  Hochspannungsimpulsgenerator nach Anspruch 3, **dadurch gekennzeichnet, dass** die mindestens eine induktiv wirkende Keramikfolie (52) beidseitig durch mindestens eine kapazitiv wirkende Keramikfolie (50) gegenüber zwei metallischen Schichten (3, 4) isoliert ist.

5. Hochspannungsimpulsgenerator nach Anspruch 1, **dadurch gekennzeichnet, dass** mindestens eine metallische Schicht aus einer metallischen Leitpaste hergestellt wird.

6. Hochspannungsimpulsgenerator nach Anspruch 1, **dadurch gekennzeichnet, dass** mindestens eine metallische Schicht aus einer Metallfolie besteht.

7. Hochspannungspulsgenerator Anspruch 1, **dadurch gekennzeichnet, dass** die Spirale mindestens n = 5 Windungen und bevorzugt höchstens n = 500 Windungen umfasst.

8. Hochspannungspulsgenerator nach Anspruch 1, **dadurch gekennzeichnet, dass** die kapazitiv wirkende Folie (50) überwiegend aus Titanat hergestellt ist.

9. Hochspannungspulsgenerator nach Anspruch 1, **dadurch gekennzeichnet, dass** die induktiv wirkende Folie (52) überwiegend aus Mn-Zn-Ferrit-Material hergestellt ist.

10. Hochspannungspulsgenerator nach Anspruch 1, **dadurch gekennzeichnet, dass** er zusammen mit einer Ladeeinheit und zusammen mit einem Kurzschlussschalter eine Zündeinheit bildet.

11. Verfahren zur Herstellung eines keramischen Spiral-Puls-Generators gemäß Anspruch 1 **gekennzeichnet, durch** folgende Schritte:

    - Aufbringen einer kapazitiv wirkenden keramischen Grünfolie (50) auf eine Trägerfolie
    - Aufbringen einer induktiv wirkenden keramischen Grünfolie (52) auf die kapazitiv wirkende keramische Grünfolie (50).
    - Aufbringen einer weiteren kapazitiv wirkenden keramischen Grünfolie (50) auf die induktiv wirkende keramische Grünfolie (52), wodurch ein Folienverbund entsteht.
    - gegebenenfalls Aufbringen einer metallischen Lage (3) auf den Folienverbund
    - Trocknen des Folienverbundes aus Grünfolien und gegebenenfalls Entfernen der Trägerfolie
    - Wickeln eines Grünkörpers aus zwei übereinandergelegten Folienverbünden
    - Laminieren des spiralförmig gewickelten Grünkörpers
    - Sintern des laminierten spiralförmigen Grünkörpers, so dass ein Spiral-Puls-Generator entsteht.

12. Verfahren zur Herstellung eines keramischen Spiral-Puls-Generators nach Anspruch 11, **dadurch gekennzeichnet, dass** die bereitgestellte Trägerfolie eine Metallfolie (3) ist.

13. Verfahren zur Herstellung eines keramischen Spiral-Puls-Generators nach Anspruch 11, **dadurch gekennzeichnet, dass** nach einem Entfernen der Trägerfolie von dem Grünfolienverbund dieser auf eine Metallfolie (3) auflaminiert wird, wobei die Metallfolie als metallische Lage dient.

14. Hochdruckentladungslampe mit einem Entladungsgefäß, das in einem Außenkolben untergebracht ist, wobei eine Zündvorrichtung in der Lampe integriert ist, die Hochspannungspulse in der Lampe erzeugt und die Zündvorrichtung im Außenkolben der Hochdruckentladungslampe untergebracht ist, **dadurch gekennzeichnet, dass** die Zündvorrichtung ein Spiral-Puls-Generator gemäß Anspruch 1 ist, wobei sich die mindestens zwei Keramikfolien (50, 52) zwischen den zwei metallischen Schichten (3, 4) befinden, und die mindestens eine induktiv wirkende Keramikfolie (52) durch die mindestens eine kapazitiv wirkende Keramikfolie (50) isoliert ist.

15. Hochdruckentladungslampe nach Anspruch 14, **dadurch gekennzeichnet, dass** die Zündvorrichtung durch ein Gestell gehaltert ist.

16. Hochdruckentladungslampe nach Anspruch 14, **dadurch gekennzeichnet, dass** die relative Permeabilität des Materials der induktiv wirkenden Folie mindestens $\mu_r$ = 1,5 beträgt.

17. Hochdruckentladungslampe nach Anspruch 16, **dadurch gekennzeichnet, dass** das Material der induktiv wirkenden Folie ein Metalloxid ist, insbesondere mit einem Anteil von mindestens 15 Gew.-% an der keramischen Mischung.

18. Hochdruckentladungslampe nach Anspruch 14, **dadurch gekennzeichnet, dass** die vom Spiral-Puls-Generator vermittelte Hochspannung direkt auf zwei Elektroden im Entladungsgefäß wirkt.

19. Hochdruckentladungslampe nach Anspruch 14, **dadurch gekennzeichnet, dass** die vom Spiral-Puls-Generator vermittelte Spannung auf eine außen am Entladungsgefäß angebrachte Zündhilfs-Elektrode wirkt.

20. Hochdruckentladungslampe nach Anspruch 14, **dadurch gekennzeichnet, dass** der Spiral-Puls-Generator aus mehreren Windungen aufgebaut ist, wobei die Anzahl n der Windungen mindestens n = 5 beträgt.

21. Hochdruckentladungslampe nach Anspruch 20, **dadurch gekennzeichnet, dass** die Anzahl n der Windungen höchstens n = 500, bevorzugt höchstens n = 100, beträgt.

22. Hochdruckentladungslampe nach Anspruch 14, **dadurch gekennzeichnet, dass** der Spiral-Puls-Generator in etwa hohlzylindrische Gestalt hat, mit einem Innendurchmesser von mindestens 10 mm.

23. Hochdruckentladungslampe nach Anspruch 14, **dadurch gekennzeichnet, dass** im Außenkolben außerdem ein Vorwiderstand untergebracht ist, der den Ladestrom des Spiral-Puls-Generators begrenzt.

24. Hochdruckentladungslampe nach Anspruch 14, **dadurch gekennzeichnet, dass** der Spiral-Puls-Generator aus einem LTCC-Material gefertigt ist.

**Claims**

1. High-voltage pulse generator based on a spiral pulse generator, the spiral pulse generator being configured as an LTCC component and being wound from at least two ceramic sheets (50, 52) and at least two metal layers (3, 4), **characterized in that** the two ceramic sheets (50, 52) are joined to form a multilayer structure comprising at least one first layer of a capacitively acting ceramic sheet (50) having a high permittivity of at least $\varepsilon_r$ = 10 and at least one second layer of an inductively acting ceramic sheet (52) having a high permeability of at least $\mu_r$ = 1.5, which are wound together with the metal layers to form a spiral.

2. High-voltage pulse generator according to Claim 1, **characterized in that** the multilayer structure of the ceramic sheets (50, 52) is located between the metal layers (3, 4) of the spiral pulse generator.

3. High-voltage pulse generator according to Claim 1, **characterized in that** the at least one inductively acting ceramic sheet (52) is insulated from at least one metal layer by the at least one capacitively acting ceramic sheet (50).

4. High-voltage pulse generator according to Claim 3, **characterized in that** the at least one inductively acting ceramic sheet (52) is insulated from two metal layers (3, 4) on each side by at least one capacitively acting ceramic sheet (50) .

5. High-voltage pulse generator according to Claim 1, **characterized in that** at least one metal layer is produced from a conductive metal paste.

6. High-voltage pulse generator according to Claim 1, **characterized in that** at least one metal layer is produced from a metal foil.

7. High-voltage pulse generator according to Claim 1, **characterized in that** the spiral comprises at least n = 5 turns and preferably at most n = 500 turns.

8. High-voltage pulse generator according to Claim 1, **characterized in that** the inductively acting sheet (52) is produced predominantly from titanate.

9. High-voltage pulse generator according to Claim 1, **characterized in that** the inductively acting sheet (52) is produced predominantly from Mn-Zn ferrite material.

10. High-voltage pulse generator according to Claim 1, **characterized in that** together with a charging unit and together with a short-circuit switch it forms an ignition unit.

11. Method for producing a ceramic spiral pulse generator according to Claim 1, **characterized by** the following steps:

    - applying an unfired capacitively acting ceramic sheet (50) onto a support sheet
    - applying an unfired inductively acting ceramic sheet (52) onto the capacitively acting unfired ceramic sheet (50)
    - applying a further unfired capacitively acting ceramic sheet (50) onto the unfired inductively acting ceramic sheet (52), so as to create a sheet composite
    - optionally applying a metal layer (3) onto the sheet composite
    - drying the sheet composite comprising the unfired sheets, and optionally removing the support sheet
    - winding an unfired body from two superimposed sheet composites
    - laminating the spirally wound unfired body
    - sintering the unfired laminated spiral body so as to create a spiral pulse generator.

12. Method for producing a ceramic spiral pulse generator according to Claim 11, **characterized in that** the support sheet provided is a metal foil (3).

13. Method for producing a ceramic spiral pulse generator according to Claim 11, **characterized in that** after the support sheet is removed from the unfired sheet composite, the latter is laminated onto a metal foil (3), the metal foil being used as a metal support.

14. High-pressure discharge lamp having a discharge vessel which is fitted in an outer bulb, the lamp comprising an integrated ignition device which generates high-voltage pulses in the lamp and the ignition device being fitted in the outer bulb of the high-pressure discharge lamp, **characterized in that** the ignition device is a spiral pulse generator according to Claim 1, the at least two ceramic sheets (50, 52) being located between the two metal layers (3, 4) and the at least one inductively acting ceramic sheet (52) being insulated by the at least one capacitively acting ceramic sheet (50).

**15.** High-pressure discharge lamp according to Claim 14, **characterized in that** the ignition device is held by a frame.

**16.** High-pressure discharge lamp according to Claim 14, **characterized in that** the relative permeability of the material of the inductively acting sheet is at least $\mu_r$ = 1.5.

**17.** High-pressure discharge lamp according to Claim 16, **characterized in that** the material of the inductively acting sheet is a metal oxide, in particular having a ceramic mixture content of at least 15 wt%.

**18.** High-pressure discharge lamp according to Claim 14, **characterized in that** the high voltage imparted by the spiral pulse generator acts directly on two electrodes in the discharge vessel.

**19.** High-pressure discharge lamp according to Claim 14, **characterized in that** the high voltage imparted by the spiral pulse generator acts on an auxiliary ignition electrode fitted externally on the discharge vessel.

**20.** High-pressure discharge lamp according to Claim 14, **characterized in that** the spiral pulse generator is constructed from a plurality of turns, the number n of turns being at least n = 5.

**21.** High-pressure discharge lamp according to Claim 20, **characterized in that** the number n of turns is at most n = 500, preferably at most n = 100.

**22.** High-pressure discharge lamp according to Claim 14, **characterized in that** the spiral pulse generator has an approximately hollow cylindrical shape with an inner diameter of at least 10 mm.

**23.** High-pressure discharge lamp according to Claim 14, **characterized in that** a ballast resistor, which limits the charging current of the spiral pulse generator, is furthermore fitted in the outer bulb.

**24.** High-pressure discharge lamp according to Claim 14, **characterized in that** the spiral pulse generator is made from an LTCC material.

**Revendications**

**1.** Générateur d'impulsions à haute tension sur la base d'un générateur d'impulsions en spirale, ledit générateur d'impulsions à spirale étant réalisé sous forme de composant LTCC et comprenant un enroulement d'au moins deux feuilles céramiques (50, 52) et d'au moins deux couches métalliques (3, 4), **caractérisé en ce que** les deux feuilles céramiques (50, 52) sont reliées pour former une structure multicouche composée d'au moins une première couche d'une feuille céramique à effet capacitif (50) présentant une permittivité élevée d'au moins $\varepsilon_r$ = 10 et d'au moins une deuxième couche d'une feuille céramique à effet inductif (52) présentant une perméabilité élevée d'au moins $\mu_r$ = 1,5, qui sont enroulées ensemble avec les couches métalliques pour former une spirale.

**2.** Générateur d'impulsions à haute tension selon la revendication 1, **caractérisé en ce que** ladite structure multicouche des feuilles céramiques (50, 52) se trouve entre les couches métalliques (3, 4) du générateur d'impulsions en spirale.

**3.** Générateur d'impulsions à haute tension selon la revendication 1, **caractérisé en ce que** ladite au moins une feuille céramique à effet inductif (52) est isolée par ladite au moins une feuille céramique à effet capacitif (50) par rapport à au moins une couche métallique.

**4.** Générateur d'impulsions à haute tension selon la revendication 3, **caractérisé en ce que** ladite au moins une feuille céramique à effet inductif (52) est isolée des deux côtés par au moins une feuille céramique à effet capacitif (50) par rapport à deux couches métalliques (3, 4).

**5.** Générateur d'impulsions à haute tension selon la revendication 1, **caractérisé en ce qu'**au moins une couche métallique est réalisée à partir d'une pâte conductrice métallique.

**6.** Générateur d'impulsions à haute tension selon la revendication 1, **caractérisé en ce qu'**au moins une couche métallique est constituée d'une feuille métallique.

**7.** Générateur d'impulsions à haute tension selon la revendication 1, **caractérisé en ce que** la spirale comprend au minimum n = 5 spires et de préférence au maximum n = 500 spires.

**8.** Générateur d'impulsions à haute tension selon la revendication 1, **caractérisé en ce que** la feuille à effet capacitif (50) est réalisée principalement en titanate.

**9.** Générateur d'impulsions à haute tension selon la revendication 1, **caractérisé en ce que** la feuille à effet inductif (52) est réalisée principalement en matériau ferrite Mn-Zn.

10. Générateur d'impulsions à haute tension selon la revendication 1, **caractérisé en ce qu'**il forme conjointement avec une unité de charge et conjointement avec un disjoncteur de court-circuit une unité d'amorçage.

11. Procédé de fabrication d'un générateur d'impulsions en spirale céramique selon la revendication 1, **caractérisé par** les étapes suivantes :

- application d'une feuille verte céramique à effet capacitif (50) sur une feuille support,
- application d'une feuille verte céramique à effet inductif (52) sur la feuille verte céramique à effet capacitif (50),
- application d'une autre feuille verte céramique à effet capacitif (50) sur la feuille verte céramique à effet inductif (52), de manière à obtenir une feuille composite,
- le cas échéant application d'une couche métallique (3) sur la feuille composite,
- séchage de la feuille composite de feuilles vertes et le cas échéant suppression de la feuille support,
- enroulement d'un corps vert comprenant deux feuilles composites superposées,
- laminage du corps vert enroulé en spirale,
- frittage du corps vert en spirale laminé, de manière à obtenir un générateur d'impulsions en spirale.

12. Procédé de fabrication d'un générateur d'impulsions en spirale céramique selon la revendication 11, **caractérisé en ce que** la feuille support fournie est une feuille métallique (3).

13. Procédé de fabrication d'un générateur d'impulsions en spirale céramique selon la revendication 11, **caractérisé en ce qu'**après un enlèvement de la feuille support de la feuille verte composite, celle-ci est laminée sur une feuille métallique (3), ladite feuille métallique servant de couche métallique.

14. Lampe à décharge à haute pression comprenant une enceinte de décharge logée dans une ampoule extérieure, un dispositif d'amorçage étant intégré dans la lampe, lequel produit des impulsions à haute tension dans la lampe, et le dispositif d'amorçage étant logé dans l'ampoule extérieure de la lampe à décharge haute pression, **caractérisée en ce que** le dispositif d'amorçage est un générateur d'impulsions en spirale selon la revendication 1, dans lequel lesdites au moins deux feuilles céramiques (50, 52) se trouvent entre les deux couches métalliques (3, 4) et ladite au moins une feuille céramique à effet inductif (52) est isolée par ladite au moins une feuille céramique à effet capacitif (50).

15. Lampe à décharge à haute pression selon la revendication 14, **caractérisée en ce que** le dispositif d'amorçage est maintenu par un support.

16. Lampe à décharge à haute pression selon la revendication 14, **caractérisée en ce que** la perméabilité relative du matériau de la feuille à effet inductif est d'au moins $\mu_r = 1,5$.

17. Lampe à décharge à haute pression selon la revendication 16, **caractérisée en ce que** le matériau de la feuille à effet inductif est un oxyde métallique, en particulier présent à raison d'au moins 15 % en poids dans le mélange céramique.

18. Lampe à décharge à haute pression selon la revendication 14, **caractérisée en ce que** la haute tension transmise par le générateur à impulsions en spirale agit directement sur deux électrodes dans l'enceinte de décharge.

19. Lampe à décharge à haute pression selon la revendication 14, **caractérisée en ce que** la tension transmise par le générateur à impulsions en spirale agit sur une électrode auxiliaire d'amorçage placée extérieurement sur l'enceinte de décharge.

20. Lampe à décharge à haute pression selon la revendication 14, **caractérisée en ce que** le générateur d'impulsions en spirale est constitué de plusieurs spires, le nombre n des spires étant au minimum n = 5.

21. Lampe à décharge à haute pression selon la revendication 20, **caractérisée en ce que** le nombre n des spires est au maximum de n = 500, de préférence au maximum de n = 100.

22. Lampe à décharge à haute pression selon la revendication 14, **caractérisée en ce que** le générateur d'impulsions en spirale a sensiblement la forme d'un cylindre creux, avec un diamètre intérieur d'au moins 10 mm.

23. Lampe à décharge haute pression selon la revendication 14, **caractérisée en ce que** dans l'ampoule extérieure est logée en outre une résistance série qui limite le courant de charge du générateur d'impulsions en spirale.

24. Lampe à décharge haute pression selon la revendication 14, **caractérisée en ce que** le générateur d'impulsions en spirale est réalisé en un matériau LTCC.

**FIG 1a**

**FIG 1b**

FIG 2

FIG 3a

FIG 3b

FIG 4

FIG 5

28 — 27 — 22 — 20 — 26 — 31 — 29 — 30

FIG 6

FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4325004 A
- US 4353012 A
- US 20030001519 A
- US 6853151 B

- DE 102006026751 A1
- DE 102005061832 A1
- DE 102006026750 A1

**In der Beschreibung aufgeführte Nicht-Patentliteratur**

- **STURM/KLEIN.** Betriebsgeräte und Schaltungen für elektrische Lampen. 1992, 193-195